# DEMANDE DE BREVET EUROPEEN

(11) **EP 1 505 733 A2**
(43) Date de publication de la demande: **09.02.2005**
(21) Numéro de dépôt: 04291656.9
(22) Date de dépôt: 01.07.2004
(51) Int. Cl.: H03K 17/0812

(54) **Dispositif de protection pour composant électronique et circuit intégré**

(30) Priorité: 02.07.2003 FR 0308056
(71) Demandeur: Institut National Polytechnique De Grenoble, 38031 Grenoble Cédex 1 (FR)
(72) Inventeur: Crebier, Jean-Christophe, 38690 Bevenais (FR); Schaeffer, Christian, 38850 Charavines (FR); Ferrieux, Jean-Paul, 38240 Meylan (FR); Barbaroux, Jean, 38400 Saint Martin d'Heres (FR); Alkayal, Fissal, 38000 Grenoble (FR)
(74) Mandataire: de Kernier, Gabriel

(57) **Abrégé**

Dispositif de protection 1 pour composant électronique de puissance intégré, comprenant un élément actif 2 équipé d'au moins deux entrées de puissance et d'une entrée de commande 5, et intégré avec le composant à protéger et un élément de commande 6 contre la surtension et relié à une entrée de commande 5 de l'élément actif 2 pour commander la mise en conduction de l'élément actif 2 lorsque la tension aux bornes du dispositif est supérieure à un seuil prédéterminé.

## Description

L'invention relève du domaine de l'électronique de puissance et plus précisément de la protection en tension d'un composant actif de puissance.

L'électronique de puissance est un moyen efficace de convertir et de contrôler de l'énergie électrique dont les applications ne cessent de s'élargir. L'augmentation de la fiabilité des systèmes de conversion est un point important pour le développement de l'électronique de puissance. Les éléments semi conducteurs apparaissent parfois comme critiques car fragiles, en particulier dans les temps courts - phénomènes de claquage, inférieurs à quelques microsecondes - où les protections classiques sont inopérantes.

L'invention vise à remédier aux inconvénients des systèmes classiques.

L'invention cherche à répondre au besoin de protection ultrarapide de composants actifs de puissance contre les surtensions.

Le dispositif de protection pour composant électronique de puissance intégré, selon un aspect de l'invention, comprend un élément actif équipé d'au moins deux entrées de puissance et d'une entrée de commande et intégré avec le composant à protéger, et un élément de commande contre la surtension relié à une entrée de commande de l'élément actif pour commander la mise en conduction de l'élément actif lorsque la tension aux bornes du dispositif est supérieure à un seuil prédéterminé.

Avantageusement, l'élément de commande comprend une diode à avalanche contrôlée. L'impédance du dispositif de protection en cas de surtension est inférieure à celle d'une diode à avalanche contrôlée haute tension classique. La tension est mieux stabilisée et le risque d'endommagement de composants est réduit. La diode à avalanche contrôlée peut être de faible calibre en courant et de faible coût.

Avantageusement, l'élément de commande comprend une résistance montée parallèlement à la diode à avalanche contrôlée.

Dans un mode de réalisation de l'invention, l'élément actif comprend au moins un transistor bipolaire.

Dans un mode de réalisation de l'invention, l'élément de commande est monté entre le collecteur et la base d'un transistor NPN ou entre la base et le collecteur d'un transistor PNP.

Le transistor bipolaire peut comprendre deux bases.

Dans un mode de réalisation de l'invention, l'élément actif comprend au moins un transistor à grille isolée.

Dans un mode de réalisation de l'invention, l'élément actif comprend au moins un transistor MOS.

Dans un mode de réalisation de l'invention, ledit élément de commande comprend une diode à avalanche contrôlée montée entre le drain et la grille et une autre diode à avalanche contrôlée montée entre la grille et la source du transistor à grille isolée.

Avantageusement, le dispositif comprend une résistance montée parallèlement à chaque diode à avalanche contrôlée.

Dans un mode de réalisation de l'invention, l'élément actif comprend un transistor J-FET, l'élément de commande étant monté en série avec transistor J-FET, la grille du transistor J-FET étant reliée à l'autre borne de l'élément de commande.

Dans un mode de réalisation de l'invention, ledit dispositif est réalisé à partir d'au moins une cellule du composant électronique de puissance équipé d'une pluralité de cellules disposées en parallèle.

L'invention propose également un circuit intégré comprenant au moins un composant actif de puissance et un dispositif de protection intégré avec ledit composant actif et comprenant un élément actif équipé d'au moins deux entrées de puissance et d'une entrée de commande, et un élément de commande contre la surtension, et relié à une entrée de commande de l'élément actif pour commander la mise en conduction de l'élément actif lorsque la tension aux bornes du dispositif est supérieure à un seuil prédéterminé.

De préférence, ledit dispositif de protection et ledit composant actif de puissance sont associés au même moyen de refroidissement. Le même radiateur peut servir à la fois au dispositif de protection et au composant actif de puissance. L'élément actif du dispositif de protection bénéficie d'un excellent refroidissement en raison de la surface d'échange thermique élevée commune au dispositif de protection et au composant actif de puissance. On peut donc prévoir un élément actif du dispositif de protection de petite taille et offrant ainsi une dynamique de réponse améliorée.

Dans un mode de réalisation de l'invention, ledit élément actif comprend un élément du composant actif de puissance. On peut se servir d'un élément du composant actif de puissance pour sa propre protection.

Dans un mode de réalisation de l'invention, le composant actif de puissance est un transistor bipolaire à grille isolée pourvu d'un transistor bipolaire interne et que ledit élément actif comprend ledit transistor bipolaire interne. On se sert ainsi du composant à protéger pour réaliser la protection. En effet, un transistor bipolaire à grille isolée est un composant à quatre couches que l'on peut modéliser par un transistor MOS commandant un transistor bipolaire principal, un autre transistor bipolaire étant disposé parallèlement au transistor MOS. On propose ici de se servir dudit transistor bipolaire principal.

Dans le cas des fortes puissances, le dispositif d'alimentation peut être à base de composants multipuces associés à l'intérieur d'un module. Pour des puissances moyennes et faibles, on pourra envisager des solutions monolithiques.

Dans un contexte de forte intégration, l'invention propose de faire cohabiter plusieurs composants ayant des fonctions différentes mais avec certaines contraintes comparables, à savoir le composant de puissance à protéger, l'élément actif et l'élément de commande associé. On bénéficie ainsi de procédés de fabrication collectifs du composant de puissance et de sa protection.

Dans un mode de réalisation de l'invention, le dispositif est réalisé à partir d'au moins une cellule du composant électronique de puissance équipé d'une pluralité de cellules disposées en parallèle. On peut prévoir d'utiliser entre 10 à 15 % des cellules pour réaliser la protection.

Une telle protection est applicable à la majeure partie des composants à grille isolée, du type MOSFET, IGBT, MBS ou autres, ou à grille non isolée, du type bipolaire ou autres.

Le dispositif peut être utilisé avec une tension de puissance continue ou alternative, selon le domaine d'application.

Le dispositif peut être incorporé dans tous les redresseurs et onduleurs actifs, dans les alimentations à découpage, dans l'entraînement des machines électriques, dans la gestion de l'énergie des réseaux de distribution, dans les produits grand public, comme l'électroménager, le multimédia, la domotique, etc.

La présente invention sera mieux comprise et d'autres avantages apparaîtront à la lecture de la description détaillée de quelques modes de réalisation pris à titre d'exemples nullement limitatifs et illustrés par les dessins annexés, sur lesquels:
- la figure 1 est une vue schématique d'une protection selon un aspect de l'invention;
- la figure 2 est une variante de la figure 1;
- la figure 3 est une vue schématique d'une protection selon un autre aspect de l'invention
- la figure 4 est une vue schématique d'un autre mode de réalisation de l'invention;
- la figure 5 est une vue schématique d'un autre mode de réalisation de l'invention;
- la figure 6 est une vue schématique d'un autre mode de réalisation de l'invention;
- la figure 7 est une vue schématique en perspective du composant dans un circuit intégré ;
- la figure 8 est une vue schématique d'un autre mode de réalisation de l'invention ; et
- la figure 9 est une vue en coupe d'un circuit selon la figure 8.

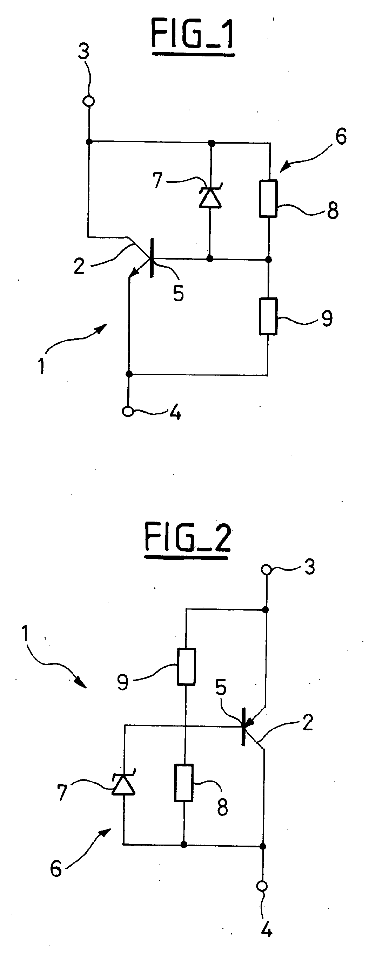

Comme on peut le voir sur la figure 1, le dispositif de protection 1 comprend un interrupteur de puissance 2 ou élément actif, ici un transistor bipolaire de type NPN et un élément de commande 6. L'interrupteur de puissance 2 comprend un collecteur 3, un émetteur 4 et une base 5.

L'élément de commande 6 comprend une diode à avalanche contrôlée 7 et une résistance 8 intégrées avec l'interrupteur de puissance 2 ou réalisées de façon discrète. La diode à avalanche contrôlée 7 comprend une cathode reliée au collecteur 3 et une anode reliée à la base 5. La résistance 8 est disposée parallèlement à la diode à avalanche contrôlée 7. La proximité de l'élément de commande et de l'interrupteur de puissance 2 due à leur intégration dans un même circuit intégré et à leur formation à proximité l'un de l'autre permet un temps de réaction très faible. Une résistance 9 disposée entre la base 5 et l'émetteur 4 de l'interrupteur de puissance 2 permet de faire chuter la tension base-émetteur et facilite le blocage de l'interrupteur de puissance 2 à la fin d'une surtension. La résistance 8 est facultative si le dispositif de protection n'est pas monté en série.

En cas de fonctionnement normal, la diode à avalanche contrôlée est bloquée et on a I_{b} = Iᵣ, avec I_{b} le courant de base de l'interrupteur de puissance 2 et Iᵣ le courant dans la résistance 8. Donc Iₑ = (ß+1) Iᵣ avec Ie le courant d'émetteur de l'interrupteur de puissance 2 et ß le gain de l'interrupteur de puissance 2. L'interrupteur de puissance 2 permet d'augmenter le calibre en courant apparent de la résistance sans que celle-ci ne soit le siège de perte supplémentaire. Ceci est intéressant pour équilibrer la tension entre plusieurs composants de puissance mis en série mais n'est pas utile en cas de protection montée seule.

En cas d'écrêtage de tension, le courant dans la diode à avalanche contrôlée 7 est noté Id sensiblement égal à Ib, Ir étant alors négligeable. On a Iₑ = (ß+1)I_{d}. Le dispositif vu de l'extérieur est une super diode à avalanche contrôlée de calibre (ß+1 )I_{d}. Ainsi, l'interrupteur de puissance 2 permet d'augmenter le calibre en courant apparent de la diode à avalanche contrôlée 7 sans que celle-ci ne soit le siège de perte supplémentaire. Ceci est particulièrement avantageux pour les applications sous tension élevée, par exemple dans le domaine de la traction ferroviaire où la tension alternative dépasse 10 kV et est souvent de 25 kV et où plusieurs composants de type transistor sont mis en série pour pouvoir supporter ladite tension élevée.

Dans le mode de réalisation de la figure 2, l'interrupteur de puissance 2 est un transistor bipolaire de type PNP. L'élément de commande 6, dépourvu de résistance parallèle à la diode à avalanche contrôlée 7, est monté entre le collecteur 4 et la base 5. Le fonctionnement est similaire à celui du dispositif de la figure 1. La résistance 9 est disposée entre la base 5 et le collecteur 3 de l'interrupteur de puissance 2.

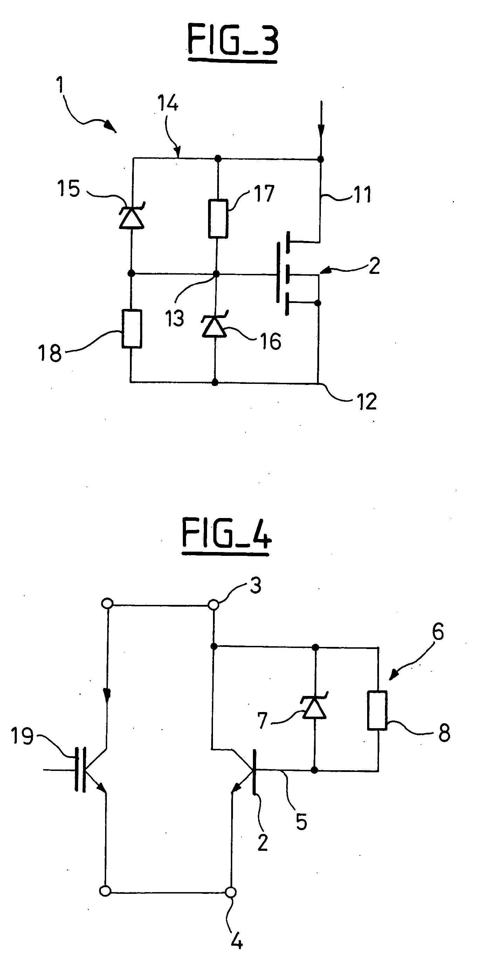

Dans le mode de réalisation de la figure 3, l'interrupteur de puissance 2 est un transistor à grille isolée comprenant un drain 11, une source 12 et une grille 13. L'élément de commande 14 comprend deux diodes à avalanche contrôlée 15 et 16 et deux résistances 17 et 18 intégrées avec l'interrupteur de puissance 2. La diode à avalanche contrôlée 15 comprend une cathode reliée au drain 11 et une anode reliée à la grille 13. La résistance 17 est disposée parallèlement à la diode à avalanche contrôlée 15. La diode à avalanche contrôlée 16 comprend une cathode reliée à la grille 13 et une anode reliée à la source 12. La résistance 18 est disposée parallèlement à la diode à avalanche contrôlée 16.

Comme dans les précédents modes de réalisation, les résistances 17 et 18 servent à l'équilibrage en mode de fonctionnement normal. Leurs valeurs sont telles que la tension V_{gs} entre la grille 13 et la source 12 est suffisamment faible pour bloquer l'interrupteur de puissance 2. Il en découle des pertes très faibles. La résistance 18 sert également à polariser la diode à avalanche contrôlée 15.

En mode d'écrêtage de tension, les tensions d'avalanche respectives des diodes à avalanche contrôlée 15 et 16 sont telles que l'interrupteur de puissance 2 est passant. Le courant dans la diode à avalanche contrôlée 15 est considérablement plus faible que le courant total passant dans le dispositif de protection en raison du gain offert par l'interrupteur de puissance 2, la diode à avalanche contrôlée 16 restant bloquée en fonctionnement normal de la protection. Il en résulte que les pertes sont concentrées dans l'interrupteur de puissance 2 et non dans les diodes à avalanche contrôlée 15 et 16. La diode à avalanche contrôlée 16 permet d'écrêter la tension grille-source et de protéger la grille de l'interrupteur de puissance 2.

Dans le mode de réalisation de la figure 4, le dispositif de protection 1 comprend un interrupteur de puissance 2 de type bipolaire NPN comme dans le mode de réalisation de la figure 1. Une résistance 9 de faible valeur est disposée entre la base 5 et l'émetteur 4 de l'interrupteur de puissance 2 pour améliorer la réponse du composant et évacuer les charges de la jonction base-émetteur lorsque la diode à avalanche contrôlée 7 est bloquée.

Le dispositif de protection 1 est associé à un composant de puissance 19 à protéger, ici un transistor IGBT. Bien entendu, on comprend que le composant 19 peut aussi être un transistor bipolaire, un transistor MOS, un transistor GTO, etc. Les collecteurs et les émetteurs de l'interrupteur de puissance 2 et du composant 19 sont reliés respectivement. De préférence, le dispositif de protection 1 et le composant 19 sont formés dans le même circuit intégré. Le dispositif de protection 1 peut alors bénéficier des moyens de refroidissement du composant 19, ce qui est particulièrement avantageux en ce sens que l'on évite de prévoir des moyens de refroidissement spécifiques au dispositif de protection.

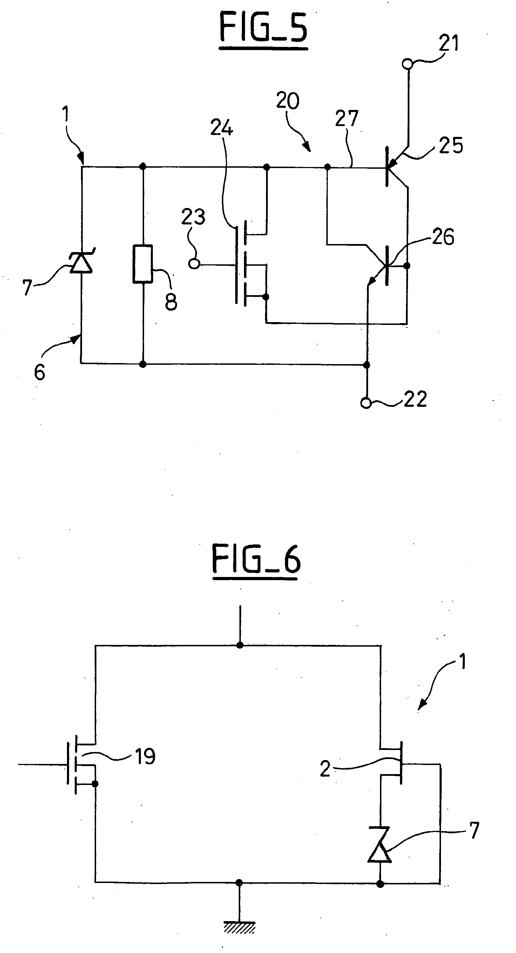

Dans le mode de réalisation de la figure 5, le dispositif de protection 1 comprend un élément de commande 6 pourvu d'une diode à avalanche contrôlée 7 et d'une résistance 8 intégrées et montées en parallèle. Le dispositif de protection 1 est imbriqué avec le composant de puissance à protéger, ici un transistor bipolaire à grille isolée (IGBT) 20, la fonction de l'élément actif du dispositif de protection étant assurée par le composant de puissance à protéger lui-même.

Le transistor IGBT 20 est représenté de façon détaillée et comprend un collecteur 21, un émetteur 22 et une grille 23. Plus précisément, le transistor IGBT 20 est modélisé électriquement par un transistor MOS 24, un transistor bipolaire PNP 25 et un transistor bipolaire NPN 26. La grille 23 forme la grille du transistor MOS 24. Le collecteur 21 forme le collecteur du transistor bipolaire PNP 25. L'émetteur 22 forme l'émetteur du transistor bipôlaire NPN 26. La base 27 du transistor bipolaire PNP 25 est reliée au collecteur du transistor bipolaire NPN 26 et au drain du transistor MOS 24. L'émetteur 22 est également relié au collecteur du transistor bipolaire PNP 25, à la base du transistor bipolaire NPN 26 et à la source du transistor MOS 24. En d'autres termes, la base et l'émetteur du transistor bipolaire NPN 26 sont court-circuitées.

Toutefois, il subsiste souvent une résistance faible, non représentée, entre la base et l'émetteur du transistor bipolaire NPN 26. Lorsque le courant passant par le transistor bipolaire PNP 25 est très élevé, la tension base-émetteur du transistor bipolaire NPN 26 peut s'élever jusqu'à rendre ce dernier passant. Ce phénomène peut être dans une certaine mesure évité en minimisant ladite résistance entre la base et l'émetteur du transistor bipolaire NPN 26.

Le dispositif de protection 1 est monté entre la base 27 et l'émetteur 22, avec la cathode de la diode à avalanche contrôlée 7 reliée à la base 27. Ainsi, lorsque la tension Vce aux bornes du circuit dépasse la tension d'avalanche de la diode à avalanche contrôlée 7, la tension V_{cb} du transistor bipolaire PNP 25 étant négligeable, la diode à avalanche contrôlée 7 se met à conduire un courant Id égal au courant I_{b} de base du transistor bipolaire PNP 25. Le transistor bipolaire PNP 25 conduit alors un courant Iₑ = β I_{b} et un courant total I_{c} = (β+1) I_{b} = (β+1)I_{d}.

Ce mode de réalisation ne nécessite pas d'élément actif supplémentaire et se sert du transistor bipolaire inhérent à un transistor IGBT pour écrêter la tension. En d'autres termes, l'élément actif du dispositif de protection est constitué ici par une partie du composant à protéger lui-même. Il est simplement nécessaire lors de la fabrication du circuit intégré de relier la base du transistor bipolaire interne du transistor IGBT à l'élément de commande. Le transistor bipolaire interne du transistor IGBT forme l'élément actif du dispositif de protection.

Comme on peut le voir sur la figure 6, le dispositif de protection 1 comprend un élément actif 2 sous la forme d'un transistor J-FET haute tension et un élément de protection 6 sous la forme d'une diode à avalanche contrôlée 7 dont la tension d'avalanche est faible par exemple de l'ordre de 2 à 3 volts. L'élément actif 2 et la diode à avalanche contrôlée 7 sont montés en série avec la cathode de la diode à avalanche contrôlée 7 reliée à la source de l'élément actif 2 et l'anode de la diode à avalanche contrôlée 7 reliée à la grille de l'élément actif 2 et à la masse du circuit. Le dispositif de protection 1 est monté parallèlement à un composant de puissance 19 à protéger, le drain du composant de puissance 19 et la source de l'élément actif 2 étant reliés et la source du composant de puissance 19 étant reliée à la cathode de la diode à avalanche contrôlée 7. Les pertes dans la diode à avalanche contrôlée 7 sont très faibles et on peut alors utiliser une diode courante de faible dimensionnement thermique, par exemple 0,25 watt, très bon marché.

À tension normale, l'élément actif 2 est bloqué et la diode à avalanche contrôlée 7 légèrement polarisée. Si la tension d'alimentation sur la source de l'élément actif 2 augmente, le courant augmente et vice-versa. Ainsi, lorsque la tension aux bornes du dispositif de protection 1 augmente, le courant passant par le transistor JFET augmente.

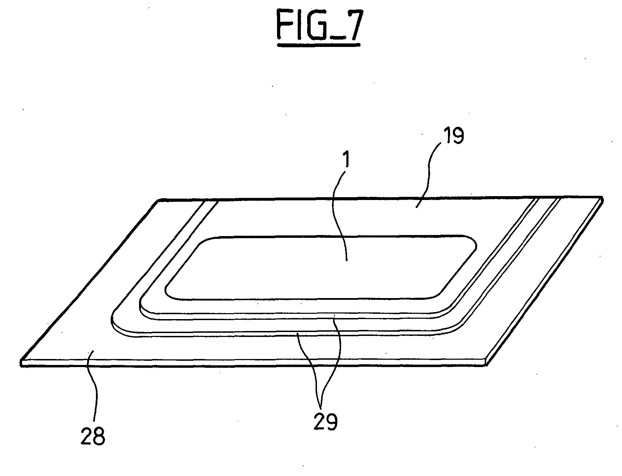

Sur la figure 7, une portion de circuit intégré comprend, sur la même puce 28, le composant de puissance à protéger 19, qui peut être de type MOSFET, et le dispositif de protection 1. Des anneaux de garde 29 sont formés autour de la puce.

Une intégration hybride correspond à des applications multipuces, où l'une des puces sera dédiée à la protection. La puce de protection, soumise aux mêmes contraintes que les puces de puissance, peut faire partie du même module pour offrir, là encore, une intégration élevée.

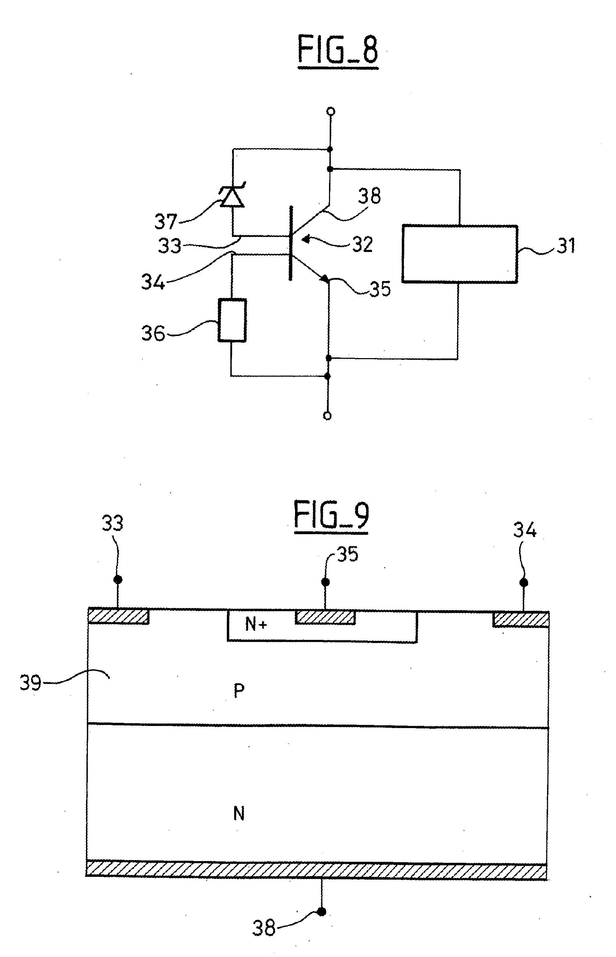

Dans le mode de réalisation illustré sur les figures 8 et 9, un dispositif de protection 30 est monté en parallèle d'un composant à protéger 31. Le dispositif de protection 30 comprend un transistor bipolaire 32 à deux bases 33 et 34 disposées d'un côté et de l'autre de l'émetteur 35. Une résistance 36 est montée entre la base 34 et l'émetteur 35. Une diode à avalanche contrôlée 37 est montée entre le collecteur 38 et la base 33, avec la cathode reliée au collecteur 38. Lorsque la base est polarisée par le courant issu de la diode à avalanche contrôlée 37, ledit courant passe entièrement par la base physique du transistor bipolaire 32 et par la couche 39 de type P avant de passer par la résistance 36. On crée ainsi un gradient de charge dans la base, ce qui améliore le fonctionnement du transistor 32.

Le dispositif de protection est applicable à l'ensemble des composants de puissance, en particulier aux composants à grille, tels que MOSFET, IGBT ou MBS.

L'invention permet d'augmenter la fiabilité et la compacité de la protection d'un interrupteur de puissance, sans en affecter le coût. A cette fin, il est particulièrement avantageux de réaliser la protection de façon intégrée avec le composant électronique de puissance actif.

L'invention propose ainsi un dispositif de protection d'un composant électronique de puissance actif, comprenant un transistor de puissance et un élément de commande contre la surtension qui peuvent être intégrés ensemble, l'élément de commande étant relié à une entrée de commande de l'élément actif pour commander la mise en conduction du transistor de puissance lorsque la tension aux bornes du dispositif est supérieure à un seuil prédéterminé.

L'invention propose ainsi un dispositif de protection rapide et susceptible de supporter de forts courants. Le dispositif de protection est apte à réaliser l'équilibrage de tension entre plusieurs composants de puissance montés en série.

L'invention offre un dispositif de protection pour composant intégré, comprenant un élément actif et un élément de commande contre la surtension intégré avec l'élément actif et relié à une entrée de commande de l'élément actif pour commander la mise en conduction de l'élément actif en cas de surtension.

## Revendications

1. Dispositif de protection (1) pour composant électronique de puissance intégré, **caractérisé par le fait qu'**il comprend un élément actif (2) équipé d'au moins deux entrées de puissance et d'une entrée de commande et intégré avec le composant à protéger, et un élément de commande (6) contre la surtension avec l'élément actif et relié à une entrée de commande (5) de l'élément actif pour commander la mise en conduction de l'élément actif lorsque la tension aux bornes du dispositif est supérieure à un seuil prédéterminé.

2. Dispositif selon la revendication 1, **caractérisé par le fait que** l'élément de commande comprend une diode à avalanche contrôlée (7).

3. Dispositif selon la revendication 2, **caractérisé par le fait que** l'élément de commande comprend une résistance (8) montée parallèlement à la diode à avalanche contrôlée.

4. Dispositif selon l'une quelconque des revendications précédentes, **caractérisé par le fait que** l'élément actif comprend au moins un transistor bipolaire.

5. Dispositif selon la revendication 4, **caractérisé par le fait que** l'élément de commande est monté entre le collecteur et la base d'un transistor NPN ou entre la base et le collecteur d'un transistor PNP.

6. Dispositif selon la revendication 4 ou 5, **caractérisé par le fait que** le transistor bipolaire comprend deux bases.

7. Dispositif selon l'une quelconque des revendications précédentes, **caractérisé par le fait que** l'élément actif comprend au moins un transistor à grille isolée.

8. Dispositif selon l'une quelconque des revendications précédentes, **caractérisé par le fait que** l'élément actif comprend au moins un transistor MOS.

9. Dispositif selon la revendication 7 ou 8, **caractérisé par le fait que** ledit élément de commande comprend une diode à avalanche contrôlée (15) montée entre le drain et la grille et une diode à avalanche contrôlée (16) montée entre la grille et la source du transistor à grille isolée.

10. Dispositif selon la revendication 9, **caractérisé par le fait qu'**il comprend une résistance (17, 18) montée parallèlement à chaque diode à avalanche contrôlée.

11. Dispositif selon la revendication 7, **caractérisé par le fait que** l'élément actif comprend un transistor J-FET, l'élément de commande étant monté en série avec transistor J-FET, la grille du transistor J-FET étant reliée à l'autre borne de l'élément de commande.

12. Dispositif selon l'une quelconque des revendications précédentes, **caractérisé par le fait que** ledit dispositif est réalisé à partir d'au moins une cellule du composant électronique de puissance équipé d'une pluralité de cellules disposées en parallèle.

13. Circuit intégré comprenant au moins un composant actif de puissance (19), **caractérisé par le fait qu'**il comprend un dispositif de protection (1) intégré avec ledit composant actif et comprenant un élément actif (2) équipé d'au moins deux entrées de puissance et d'une entrée de commande, et un élément de commande (6) contre la surtension relié à une entrée de commande de l'élément actif pour commander la mise en conduction de l'élément actif lorsque la tension aux bornes du dispositif est supérieure à un seuil prédéterminé.

14. Circuit selon la revendication 13, **caractérisé par le fait que** ledit dispositif de protection et ledit composant actif de puissance sont associés au même moyen de refroidissement.

15. Circuit selon la revendication 13 ou 14, **caractérisé par le fait que** ledit élément actif comprend un élément du composant actif de puissance.

16. Circuit selon la revendication 15, **caractérisé par le fait que** le composant actif de puissance est un transistor bipolaire à grille isolée (20) pourvu d'un transistor bipolaire interne (25) et que ledit élément actif comprend ledit transistor bipolaire interne.

17. Circuit selon l'une quelconque des revendications 13 à 16, **caractérisé par le fait qu'**il comprend une pluralité de composants actifs en série.
